Europäisches Patentamt

European Patent Office

Office européen des brevets

(11) Numéro de publication : **0 468 830 A2**

# (12) DEMANDE DE BREVET EUROPEEN

(21) Numéro de dépôt : **91401707.4**

(22) Date de dépôt : **25.06.91**

(51) Int. Cl.⁵ : **G01R 19/165, H02H 3/16, G01R 15/07**

(30) Priorité : **26.06.90 FR 9007993**

(43) Date de publication de la demande :
**29.01.92 Bulletin 92/05**

(84) Etats contractants désignés :
**BE CH DE ES IT LI**

(71) Demandeur : **APPLICATIONS ET UTILISATIONS DES PROPRIETES ELECTRIQUES DES MATERIAUX (AUPEM)**
**Zone Industrielle de la Saulaie**
**F-45500 Gien (FR)**

(72) Inventeur : **Arlot, François**
**45 Route de Sully**
**F-45500 Poilly lez Gien (FR)**
Inventeur : **Gresland, Olivier**
**67 Avenue du 11 Novembre**
**F-94170 Le Perreux (FR)**

(74) Mandataire : **CABINET BONNET-THIRION**
**95 Boulevard Beaumarchais**
**F-75003 Paris (FR)**

(54) **Boîtier de sécurité pour enseigne haute tension.**

(57)    Il s'agit d'un boîtier de sécurité (18) du genre propre à recevoir, sur une borne d'entrée (E), un signal délivré par un circuit de détection sensible à un éventuel amorçage à la terre de la partie haute tension de l'enseigne concernée, et à piloter, en conséquence, par une borne de sortie (T), l'alimentation du transformateur desservant cette enseigne.

   Suivant une disposition de l'invention, ce boîtier de sécurité (18) porte, en évidence, un voyant lumineux (28), qui se trouve sous tension, et donc allumé, lorsqu'un tel défaut d'amorçage à la terre a été détecté.

   Application aux enseignes haute tension.

FIG. 5

EP 0 468 830 A2

La présente invention concerne d'une manière générale les enseignes haute tension, c'est-à-dire les enseignes qui, mettant en oeuvre un ou plusieurs tubes à décharge, nécessitent, pour leur alimentation, une tension relativement élevée.

Elle vise plus particulièrement le boîtier de sécurité qu'il est usuel de leur associer pour pallier les conséquences d'un éventuel défaut d'amorçage à la terre de leur partie haute tension, à la suite par exemple d'un défaut d'isolation sur celle-ci.

De réalisation relativement rudimentaire, les boîtiers de sécurité de ce type connus à ce jour, qui sont utilisés seuls ou qui sont intégrés à un coffret de commande regroupant plusieurs autres fonctions, comportent, pour l'essentiel, une borne d'entrée par laquelle ils sont aptes à recevoir un signal délivré par un circuit de détection sensible au défaut d'amorçage à relever, et une borne de sortie par laquelle ils sont aptes à piloter en conséquence l'alimentation de l'enseigne, en provoquant une coupure de cette alimentation lorsqu'intervient un tel défaut d'amorçage.

Leur fonction propre est donc une simple fonction de coupure d'alimentation, sans accompagnement de celle-ci par une quelconque fonction de signalisation.

Il en résulte que l'usager ne peut pas avoir connaissance d'une éventuelle extinction de son enseigne autrement qu'en constatant de visu cette extinction, alors même qu'il n'a pas nécessairement à vue cette enseigne.

Lorsque, comme cela est le cas le plus fréquent, les boîtiers de sécurité du genre en cause sont intégrés à un coffret ou une armoire de commande, il leur est cependant usuellement associé, pour l'obtention d'autres fonctions, divers autres composants, et, notamment, un premier interrupteur, qui, à la disposition de l'usager, est un interrupteur de marche arrêt, un deuxième interrupteur, qui, pour un éventuel dépannage, est propre à une mise hors service du circuit de détection, et, pour l'intervention éventuelle de divers autres organes de commande annexes, tels que, par exemple, un interrupteur crépusculaire, un interrupteur horaire, et un interrupteur qui, pour être à la disposition des pompiers, est accessible de l'extérieur, au niveau même de l'enseigne, une pluralité de borniers.

Ainsi pris isolément, ces divers composants sont relativement encombrants à loger, et ils nécessitent pour leur connexion un câblage, qui, lui-même relativement encombrant, est en outre relativement complexe à réaliser.

La présente invention a d'une manière générale pour objet des dispositions de nature à minimiser ces inconvénients.

De manière plus précise, elle a pour objet un boîtier de sécurité pour enseigne haute tension, qui est du genre propre à recevoir sur une borne d'entrée un signal délivré par un circuit de détection sensible à un éventuel défaut d'amorçage à la terre sur la partie haute tension d'une telle enseigne et à piloter en conséquence, par une borne de sortie, l'alimentation de cette enseigne, et qui, selon une première disposition de l'invention, est caractérisé en ce qu'il porte en évidence un voyant lumineux, qui se trouve sous tension, et donc allumé, lorsqu'un tel défaut d'amorçage à la terre a été détecté, et que, par conséquent, l'alimentation de l'enseigne a été coupée.

Ainsi, lorsqu'une telle coupure d'alimentation est intervenue à la suite d'un défaut d'amorçage sur la partie haute tension de son enseigne, l'usager en est averti par la seule consultation du boîtier de sécurité suivant l'invention, sans qu'il soit nécessaire pour lui de contrôler de visu l'état de cette enseigne.

Suivant une deuxième disposition de l'invention, un interrupteur étant prévu pour permettre de mettre hors service le circuit de détection, cet interrupteur, communément dit interrupteur de dépannage, est intégré au boîtier de sécurité et est implanté à un endroit de celui-ci où il n'est pas immédiatement accessible à l'usager.

Autrement dit, le boîtier de sécurité suivant l'invention comporte par lui-même cet interrupteur de dépannage.

Par exemple, ce boîtier de sécurité se présentant préférentiellement sous la forme d'un module auquel de manière usuelle il est associé un capot ou plastron qui le recouvre en totalité à l'exclusion de sa seule partie de façade, l'interrupteur de dépannage est implanté sous ce capot ou plastron.

Il est donc nécessaire de procéder à la dépose de ce capot ou plastron avant d'avoir accès à cet interrupteur de dépannage, ce qui évite toute intervention malencontreuse ou fortuite sur lui.

En outre, cet interrupteur de dépannage étant intégré au boîtier de sécurité lui-même, l'encombrement de l'ensemble s'en trouve avantageusement réduit d'autant et le câblage à réaliser s'en trouve conjointement avantageusement simplifié.

Suivant une troisième disposition de l'invention, le boîtier de sécurité suivant l'invention est encore caractérisé en ce que, sa borne d'entrée étant sous le contrôle d'un interrupteur de marche arrêt à la disposition de l'usager, il comporte par lui-même cet interrupteur de marche arrêt.

Autrement dit, cet interrupteur de marche arrêt est lui aussi intégré.

L'encombrement de l'ensemble s'en trouve encore avantageusement réduit d'autant, et le câblage simplifié en conséquence.

De préférence, il est associé, suivant l'invention, à l'interrupteur de marche arrêt, un voyant lumineux dont l'alimentation est asservie à l'état de celui-ci.

L'information de l'usager s'en trouve avantageusement plus complète.

Enfin, suivant une quatrième disposition de l'invention, le boîtier de sécurité suivant l'invention est encore caractérisé en ce qu'il comporte des bornes d'entrée supplémentaires, pour l'intervention éventuelle d'organes de commande annexes.

Ainsi, ces organes de commande annexes interviennent avantageusement sur le circuit de commande même de l'enseigne haute tension concernée, et non pas sur le circuit de puissance de celle-ci, au bénéfice de leur réalisation.

En bref, le boîtier de sécurité suivant l'invention permet avantageusement de gagner de la place et de simplifier le câblage à assurer.

Il est en outre avantageusement plus performant, tout en conduisant, pour l'ensemble, à un prix de revient plus réduit.

Les caractéristiques et avantages de l'invention ressortiront d'ailleurs de la description qui va suivre, à titre d'exemple, en référence aux dessins schématiques annexés sur lesquels :

la figure 1 est un bloc diagramme représentatif d'une enseigne haute tension, du transformateur assurant sa desserte, et du circuit de détection de défaut d'amorçage associé à l'ensemble ;

la figure 2 est, avec un arrachement, une vue en perspective d'un boîtier de sécurité suivant l'invention, représenté en place au sein d'un coffret ;

la figure 3 est une vue en plan de ce boîtier de sécurité, suivant la flèche III de la figure 2 ;

la figure 4 est un schéma des circuits qu'il comporte ;

la figure 5 est une vue en plan qui, reprenant, à échelle inférieure, celle de la figure 3, illustre un mode de montage du boîtier de sécurité suivant l'invention.

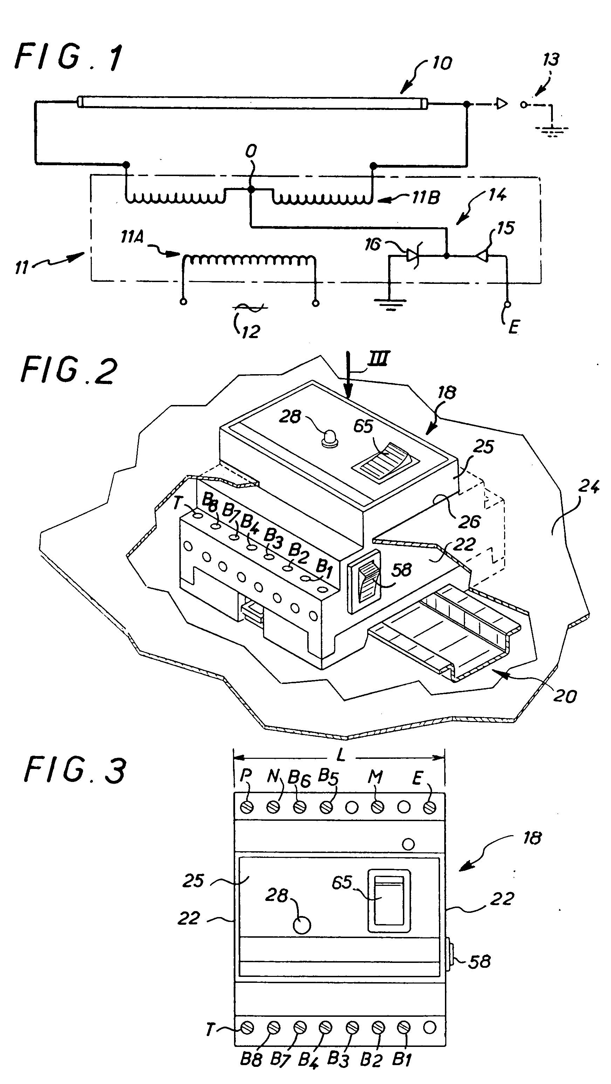

Tel qu'illustré sur la figure 1, il s'agit, globalement, d'assurer la desserte d'une enseigne haute tension 10, c'est-à-dire d'une enseigne constituée d'un ou plusieurs tubes à décharge.

De manière usuelle, cette desserte implique la mise en oeuvre d'un transformateur élévateur de tension 11, dont le primaire 11A est à brancher sur une source basse tension, en pratique le secteur 12, et dont le secondaire 11B est appliqué aux bornes de l'enseigne 10 à desservir.

De manière usuelle, également, il est associé, au transformateur 11, un circuit de détection 14, qui, tel que schématisé, en 13, en traits interrompus, sur la figure 1, est sensible à un éventuel défaut d'amorçage à la terre, de la partie haute tension de l'ensemble, cette partie haute tension comportant tant le secondaire 11B de ce transformateur 11 que les connexions le reliant aux bornes de l'enseigne 10.

En pratique, ce circuit de détection 14 se réduit à un piquage sur le point milieu 0 du secondaire 11B. Soit E sa borne.

Dans le cas d'un défaut d'amorçage à la terre, il se produit un déséquilibre de courant dans les deux demi-enroulements du secondaire 11B, et, donc, l'apparition, sur la borne E du circuit de détection 14, d'un signal de tension.

Dans la forme de réalisation représentée, ce signal de tension est dûment contrôlé par une diode d'orientation 15 et dûment écrêté par une diode Zener 16.

De manière usuelle, enfin, il est mis en oeuvre, pour l'exploitation de ce signal de tension, ou signal de défaut, un boîtier de sécurité 18 propre à le recevoir sur une borne d'entrée E et propre à piloter en conséquence, par une borne de sortie T, l'alimentation de l'enseigne 10, et, donc, plus précisément, l'alimentation du primaire 11A du transformateur 11.

Outre cette borne d'entrée E et cette borne de sortie T, le boîtier de sécurité 18 présente deux bornes d'entrée P, N pour son raccordement au secteur 12.

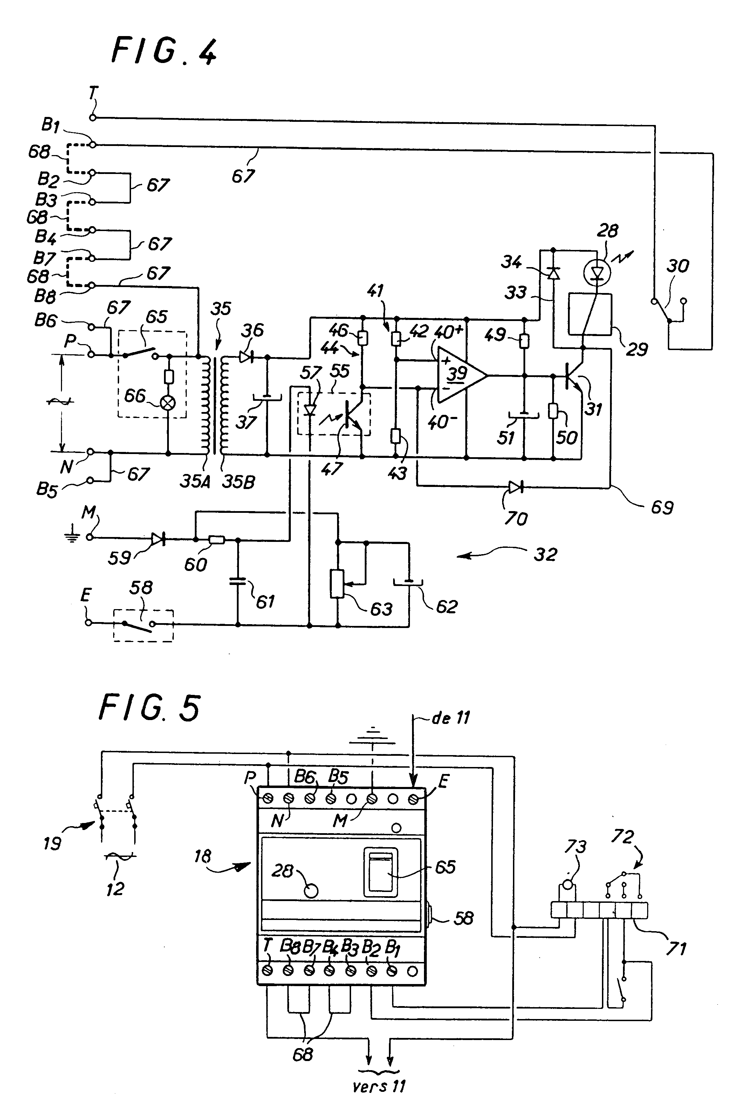

Tel que représenté à la figure 5, ce raccordement se fait en pratique par l'intermédiaire d'un disjoncteur 19.

Suivant une disposition de l'invention, le boîtier de sécurité 18 se présente sous la forme d'un module, qui, à la manière de nombreux appareils électriques, est à rapporter par simple encliquetage sur un quelconque support 20, en pratique un rail, tel que représenté sur la figure 2.

Les dispositions correspondantes étant bien connues par elles-mêmes, et ne relevant pas de la présente invention, elles ne seront pas décrites ici.

Par exemple, le boîtier de sécurité 18 suivant l'invention a, transversalement, c'est-à-dire perpendiculairement à ses parois latérales 22, une largeur L égale à quatre fois la largeur d'un module de base dans ce domaine.

Lorsqu'il est mis en oeuvre dans un coffret ou une armoire, le boîtier de sécurité 18 suivant l'invention peut ainsi être traité comme les autres appareils électriques également mis en oeuvre dans ce coffret ou cette armoire.

Comme à ceux-ci, il lui est donc usuellement associé un capot ou plastron 24 qui le recouvre en totalité, à l'exclusion de sa seule partie de façade 25, cette partie de façade 25 émergeant de ce capot ou plastron 24 à la faveur d'une fenêtre 26 prévue à cet effet dans celui-ci.

Suivant une disposition de l'invention, le boîtier de sécurité 18 porte en évidence un voyant lumineux 28, qui se trouve sous tension, et donc allumé, lorsqu'un défaut d'amorçage à la terre a été détecté.

En pratique, dans la forme de réalisation représentée, ce voyant lumineux 28 est disposé sur la partie de façade 25 de ce boîtier de sécurité 18.

Par exemple, et tel que représenté sur la figure 4, il est en série avec un relais 29 qui, par son contact 30, contrôle la borne de sortie T, ce contact 30 étant interposé entre cette borne de sortie T et la borne d'entrée P, et sur l'alimentation duquel est interposé, suivant des modalités décrites plus en détail ultérieurement, un interrupteur commandé 31, en pratique un simple transistor, contrôlé, suivant des modalités également décrites plus en détail ultérieurement, par un circuit de maintien 32 recevant, par la borne d'entrée E, le signal de défaut correspondant.

Par exemple, le voyant lumineux 28 est constitué par une diode électroluminescente, communément dite LED, et il s'agit par exemple d'une diode électroluminescente rouge.

De préférence, et tel que représenté, pour éviter des surtensions, il est établi, aux bornes de ce voyant lumineux 28 et du relais 29, une dérivation 33, qui, dûment contrôlée par une diode d'orientation 34, est propre à assurer une démagnétisation convenable de la bobine de ce relais 29.

Quant à l'interrupteur commandé 31, il s'agit, par exemple, et tel que représenté, d'un simple transistor.

Quoi qu'il en soit, le voyant lumineux 28, le relais 29, et cet interrupteur commandé 31 sont globalement en série aux bornes du secondaire 35B d'un transformateur 35, qui est destiné à assurer l'alimentation de l'ensemble, et dont le primaire 35A est à cet effet branché sur les bornes d'entrée P et N recevant le secteur 12.

Une diode 36 assure le redressement nécessaire, et un condensateur 37 est prévu pour former réservoir d'énergie.

Dans la forme de réalisation représentée, le circuit de maintien 32 comporte, pour minimiser sa sensibilité à d'éventuels parasites, un amplificateur opérationnel 39.

L'entrée positive 40$^+$ de cet amplificateur opérationnel 39 est reliée au point milieu d'un premier pont diviseur 41, qui est établi aux bornes du secondaire 35B du transformateur 35 et reçoit donc la tension d'alimentation de l'ensemble, et dont l'une et l'autre des branches sont chacune respectivement formées de résistances 42, 43.

Conjointement, l'entrée négative 40$^-$ de cet amplificateur opérationnel 39 est reliée au point milieu d'un second pont diviseur 44, qui lui aussi est établi aux bornes du secondaire 35B du transformateur 35 et reçoit donc lui aussi la tension d'alimentation de l'ensemble, et dont l'une des branches est formée d'une résistance 46, tandis que l'autre comporte un interrupteur commandé 47 piloté par le circuit de détection 14, en étant en pratique formé par ce seul interrupteur commandé 47.

La sortie de l'amplificateur opérationnel 39 est reliée à la base du transistor constituant l'interrupteur commandé 31.

Il est en outre bien entendu prévu des résistances 49, 50 propres à une polarisation convenable de ce dernier.

Enfin, il est prévu, sur le circuit de cette base de ce transistor, entre l'amplificateur opérationnel 39 et lui, un condensateur 51 propre à l'introduction d'un certain retard.

Comme l'interrupteur commandé 31, l'interrupteur commandé 47 peut, par exemple, et tel que représenté, être constitué par un simple transistor.

Tel que représenté, l'émetteur de celui-ci est relié à la masse.

De préférence, et tel que représenté, pour l'établissement d'une coupure voltaïque entre le transformateur 11 et le boîtier de sécurité 18, le circuit de maintien 32 met par ailleurs en oeuvre un coupleur opto-électronique 55.

Par exemple, ce coupleur opto-électronique 55 comporte, en regard de la base du transistor constituant l'interrupteur commandé 47, une diode électroluminescente 57 dûment établie entre la borne d'entrée E et une borne de masse M.

Suivant une disposition de l'invention, un interrupteur de dépannage 58 étant prévu pour permettre de mettre hors service le circuit de détection 14, cet interrupteur de dépannage 58 est interposé sur le circuit de maintien 32, et il est implanté à un endroit du boîtier de sécurité 18 où il n'est pas immédiatement accessible à l'usager.

Par exemple, et tel que représenté, il est implanté sur l'une des parois latérales 22 de ce boîtier de sécurité 18, à distance de sa partie de façade 25, et donc sur le capot 24.

Il est donc nécessaire de procéder à une dépose de ce capot 24 pour y avoir accès.

Quoi qu'il en soit, suivant l'invention, le boîtier de sécurité 18 comporte par lui-même cet interrupteur de dépannage 58.

En pratique, il est disposé immédiatement en aval de la borne d'entrée E.

En aval de la borne de masse M interviennent, par ailleurs, une diode d'orientation 59, pour le blocage d'éventuelles alternances négatives en cas d'amorçage, et, pour le filtrage nécessaire, une résistance 60 et deux condensateurs 61, 62.

Dans la forme de réalisation représentée, il est en outre prévu un potentiomètre 63, pour le réglage de la partie du courant de fuite destinée à traverser la diode électroluminescente 57.

Suivant une autre disposition de l'invention, la borne d'entrée P du boîtier de sécurité 18 étant sous le contrôle d'un interrupteur de marche arrêt 65, ce boîtier de sécurité 18 comporte par lui-même cet interrupteur de marche arrêt 65.

Autrement dit, comme l'interrupteur de dépannage 58, cet interrupteur de marche arrêt 65 lui est intégré.

En pratique, cet interrupteur de marche arrêt 65 intervient sur le primaire 35A du transformateur 35.

Il est donc en série avec le contact 30 du relais 29.

De préférence, et tel que représenté, il est associé, à cet interrupteur de marche arrêt 65, un autre voyant lumineux 66 dont l'alimentation est asservie à son état.

Par exemple, il s'agit d'un tube à décharge, qui est monté en parallèle par rapport au primaire 35A du transformateur 35, entre ce primaire 35A et l'interrupteur de marche arrêt 65, et qui est disposé sous la touche de commande, choisie translucide à cet effet, de ce dernier.

Quoi qu'il en soit, ce voyant lumineux 66 est de préférence d'une couleur différente de celle du voyant lumineux 28.

Par exemple, il est de couleur verte.

Suivant une autre disposition de l'invention, et tel que représenté, le boîtier de sécurité 18 comporte, en attente, en sus des bornes T, P, N, M et E déjà mentionnées ci-dessus, des bornes d'entrée supplémentaires, et notamment des bornes d'entrée B1, B2, B3, B4, B5, B6, B7 et B8, pour l'intervention éventuelle d'organes de commande divers.

Par construction, c'est-à-dire par des liaisons 67 internes au boîtier de sécurité 18, et tel que représenté par des traits continus sur la figure 4, la borne B1 est reliée à la borne centrale du contact 30 du relais 29, la borne B2 est reliée à la borne B3, la borne B4 est reliée à la borne B7, la borne B5 est reliée à la borne N, la borne B6 est reliée à la borne P, en amont de l'interrupteur de marche arrêt 65, et la borne B8 est reliée à cette même borne P en aval de cet interrupteur de marche arrêt 65.

En l'absence d'organes de commande extérieurs, il est en outre tenu, à l'extérieur du boîtier de sécurité 18, et tel que schématisé en tirets sur la figure 4, entre les bornes B1-B2, B3-B4, et B7-B8, des cavaliers amovibles 68.

C'est donc à travers ces cavaliers amovibles 68 et les liaisons internes 67 intervenant entre les bornes en cause, que, dans la forme de réalisation représentée, le contact 30 du relais 29 est en série avec l'interrupteur de marche arrêt 65.

Enfin, suivant une autre disposition de l'invention, le circuit de maintien 32 comporte une fonction mémoire propre à maintenir conducteur l'interrupteur commandé 31 interposé sur l'alimentation du relais 29 une fois devenu passant cet interrupteur commandé 31.

Dans la forme de réalisation représentée, cette fonction mémoire est assurée par une dérivation 69, qui, dûment contrôlée par une diode d'orientation 70, est établie entre, d'une part, l'entrée négative 40⁻ de l'amplificateur opérationnel 39, et, d'autre part, l'une des bornes de l'interrupteur commandé 31.

Il s'agit en pratique de celle formée par le récepteur du transistor constituant cet interrupteur commandé 31.

Comme celui de l'émetteur du transistor constituant l'interrupteur commandé 47, l'émetteur du transistor constituant cet interrupteur commandé 31 est par ailleurs relié à la masse.

Dans la forme de mise en oeuvre illustrée par la figure 5, les bornes B1 et B2 sont mises à profit pour l'intervention, par l'intermédiaire d'un bornier 71, d'un interrupteur horaire 72.

Le cavalier amovible 68 correspondant est donc dans ce cas éliminé.

Dans la forme de mise en oeuvre représentée, le bornier 71 est également mis à profit pour le branchement, sur le secteur 12, du moteur 73 nécessaire à l'entraînement de l'horloge, non représentée, commandant l'interrupteur horaire 72.

Quant aux bornes B5 et B6, elles permettent, si désiré, un repiquage de la tension du secteur 12, pour l'alimentation, par exemple, d'autres boîtiers ou appareils électriques.

Au montage, les bornes du primaire 11A du transformateur 11 sont reliées aux bornes T et N du boîtier de sécurité 18, tel qu'indiqué à la figure 5, cependant que sa borne E est elle-même reliée à la borne E de ce boîtier de sécurité 18.

En service, les interrupteurs 58 et 65 sont fermés.

Le voyant lumineux 66 est donc allumé.

En l'absence de signal de tension sur la borne E du boîtier de sécurité 18, le transistor constituant l'interrupteur commandé 47 est bloqué, et l'amplificateur opérationnel 39, qui, sur son entrée 40⁺, reçoit une tension liée à la tension d'alimentation présente aux bornes du secondaire 35B du transformateur 35, mais inférieure à cette tension d'alimentation, reçoit à pleine valeur cette dernière sur son entrée négative 40⁻.

Les dispositions sont telles que sa sortie est alors à son niveau bas, et que, par conséquent, le transistor constituant l'interrupteur commandé 31 est lui-même bloqué.

En pratique, à la mise sous tension, le retard dû au condensateur 51 permet avantageusement d'éviter un déblocage intempestif de ce transistor.

Le voyant lumineux 28 est donc normalement éteint, et le relais 29 n'étant lui-même pas sous tension, son contact 30 est normalement fermé, ce qui autorise effectivement l'alimentation de l'enseigne 10.

En cas d'un défaut d'amorçage sur la partie haute tension de cette enseigne 10, le signal de tension apparaissant sur la borne E du boîtier de sécurité 18 provoque, par l'intermédiaire du coupleur opto-électronique 55, le déblocage du transistor constituant l'interrupteur commandé 31.

Il en résulte l'application, à l'entrée négative 40⁻ de l'amplificateur opérationnel 39, non plus, comme précédemment, de la tension d'alimentation de l'ensemble, mais du potentiel de l'émetteur du transistor constituant l'interrupteur commandé 47, et, donc, en pratique, de la masse.

L'amplificateur opérationnel 39 formant comparateur, sa sortie passe dès lors à son niveau haut, et il en résulte le déblocage du transistor constituant l'interrupteur commandé 31, et, donc, simultanément, l'entrée en action du relais 29 et l'allumage du voyant lumineux 28.

Par son contact 30, le relais 29 coupe alors l'alimentation du transformateur 11, en provoquant ainsi l'extinction de l'enseigne 10.

Conjointement, la dérivation formant mémoire 69 ramène, sur l'entrée négative 40⁻ de l'amplificateur opérationnel 39, à travers le transistor constituant l'interrupteur commandé 31, le potentiel de l'émetteur du transistor constituant l'interrupteur commandé 47, c'est-à-dire la masse.

Ainsi donc, la sortie de cet amplificateur opérationnel 39 reste à son niveau haut même si plus aucun signal de tension n'est présent sur la borne E du boîtier de sécurité 18.

Le relais 29 reste ainsi avantageusement autoalimenté, il en est de même pour le voyant lumineux 28, et l'alimentation de l'enseigne 10 continue à être interrompue.

Une intervention sur l'interrupteur de marche arrêt 65 permet cependant d'interrompre l'alimentation du relais 29, et donc d'éteindre le voyant lumineux 28.

Quant à l'interrupteur 58, il permet, en cas de nécessité, notamment pour un dépannage, de mettre hors service le circuit de détection 14.

En bref, si les voyants lumineux 66 et 28 sont simultanément allumés, l'usager est informé que la basse tension est présente, mais que, par suite d'un défaut d'amorçage à la terre sur la haute tension, son enseigne 10 est éteinte.

Bien entendu, la présente invention ne se limite pas à la forme de réalisation décrite et représentée, mais englobe toute variante d'exécution.

En particulier, l'interrupteur de dépannage peut être implanté ailleurs que sur une partie latérale du boîtier, par exemple sur une partie de la paroi de façade de celui-ci inaccessible à l'usager ou sur sa paroi opposée, notamment dans le cas où deux boîtiers doivent être accolés l'un à l'autre.

Il va de soi enfin que, le boîtier de sécurité suivant l'invention étant évolutif, on ne sortirait pas du cadre de l'invention en l'adaptant à toute éventuelle future norme ou réglementation en la matière.

## Revendications

1. Boîtier de sécurité pour enseigne haute tension, du genre propre à recevoir sur une borne d'entrée (E) un signal délivré par un circuit de détection (14) sensible à un éventuel défaut d'amorçage à la terre sur la partie haute tension de cette enseigne et à piloter en conséquence, par une borne de sortie, l'alimentation de celle-ci, caractérisé en ce qu'il porte en évidence un voyant lumineux (28), qui se trouve sous tension, et donc allumé, lorsqu'un tel défaut d'amorçage à la terre a été détecté.

2. Boîtier de sécurité suivant la revendication 1, caractérisé en ce que ledit voyant lumineux (28) est en série avec un relais (29), qui contrôle la borne de sortie (T) concernée, et sur l'alimentation duquel est interposé un interrupteur commandé (31) lui-même contrôlé par un circuit de maintien (32) recevant le signal correspondant.

3. Boîtier de sécurité suivant la revendication 2, caractérisé en ce que le circuit de maintien (32) comporte un amplificateur opérationnel (39) dont l'une des entrées est reliée au point milieu d'un pont diviseur (44), et l'une des branches de ce pont diviseur (44) comporte un interrupteur commandé (47) piloté par le circuit de détection (14).

4. Boîtier de sécurité suivant l'une quelconque des revendications 2, 3, caractérisé en ce que le circuit de maintien (32) comporte une fonction mémoire propre à maintenir conducteur l'interrupteur commandé (31) interposé sur l'alimentation du relais (29) une fois devenu passant cet interrupteur commandé (31).

5. Boîtier de sécurité suivant les revendications 3 et 4, prises conjointement, caractérisé en ce que la fonction mémoire que comporte le circuit de maintien (32) est assurée par une dérivation (69), qui, dûment contrôlée par une diode d'orientation (70), est établie entre, d'une part, l'entrée (40⁻) concernée de l'amplificateur opérationnel (39), et, d'autre part, l'une des bornes de l'interrupteur commandé (31) interposé sur l'alimentation du relais (29).

6. Boîtier de sécurité suivant l'une quelconque des revendications 2 à 5, caractérisé en ce que, pour l'établissement d'une coupure voltaïque, le circuit de maintien (32) met en oeuvre un coupleur opto-électronique (55).

7. Boîtier de sécurité suivant l'une quelconque des revendications 1 à 6, caractérisé en ce que, un interrupteur de dépannage (58) étant prévu pour permettre de mettre hors service le circuit de détection (14), il comporte par lui-même cet interrupteur de dépannage (58).

8. Boîtier de sécurité suivant la revendication 7, caractérisé en ce que ledit interrupteur de dépannage (58) est implanté en un endroit où il n'est pas immédiatement accessible à l'usager.

9. Boîtier de sécurité suivant la revendication 8, et auquel il est associé un capot ou plastron (24) qui le recouvre en totalité à l'exclusion de sa partie de façade (25), caractérisé en ce que ledit interrupteur de dépannage (58) est implanté sous ledit capot ou plastron (24).

10. Boîtier de sécurité suivant l'une quelconque des revendications 8, 9, caractérisé en ce que ledit interrupteur de dépannage (58) est implanté sur l'une de ses parois latérales (22).

11. Boîtier de sécurité suivant les revendications 2 et 7, prises conjointement, caractérisé en ce que ledit interrupteur de dépannage (58) intervient sur le circuit de maintien (32).

12. Boîtier de sécurité suivant l'une quelconque des revendications 1 à 11, caractérisé en ce que sa borne d'entrée (P) étant sous le contrôle d'un interrupteur de marche arrêt (65) à la disposition de l'usager, il comporte par lui-même cet interrupteur de marche arrêt (65).

13. Boîtier de sécurité suivant la revendication 12, caractérisé en ce que audit interrupteur de marche arrêt (65) est associé un autre voyant lumineux (66) dont l'alimentation est asservie à son état.

14. Boîtier de sécurité suivant l'une quelconque des revendications 1 à 13, caractérisé en ce qu'il comporte des bornes d'entrée supplémentaires (B1, B2, B3, B4, B7, B8), pour l'intervention éventuelle d'organes de commande annexes.

15. Boîtier de sécurité suivant l'une quelconque des revendications 1 à 14, caractérisé en ce qu'il se présente sous la forme d'un module à rapporter par simple encliquetage sur un support (20).

# FIG.1

# FIG.2

# FIG.3

# FIG. 4

# FIG. 5